# EUROPÄISCHE PATENTSCHRIFT

(11) **EP 1 611 779 B1**
(45) Veröffentlichungstag und Bekanntmachung des Hinweises auf die Patenterteilung: **26.07.2006**
(21) Anmeldenummer: 03785553.3
(22) Anmeldetag: 05.12.2003
(51) Int. Cl.: H05K 13/04

(54) **BESTÜCKKOPF ZUM AUFNEHMEN, TRANSPORTIEREN UND AUFSETZEN VON BAUELEMENTEN**
EQUIPMENT HEAD FOR LIFTING, TRANSPORTING AND PLACING COMPONENTS
TETE D'EQUIPEMENT PERMETTANT DE PRELEVER, TRANSPORTER ET POSER DES COMPOSANTS

(30) Priorität: 09.04.2003 DE 10316293
(43) Veröffentlichungstag der Anmeldung: 04.01.2006
(73) Patentinhaber: SIEMENS AKTIENGESELLSCHAFT, 80333 München (DE)
(72) Erfinder: BURGER, Stefan, 81379 München (DE)
(86) Internationale Anmeldenummer: PCT/DE2003/004009
(87) Internationale Veröffentlichungsnummer: WO 2004/093516

(56) Entgegenhaltungen:
- US-A- 5 351 872
- US-A- 5 831 504
- US-A- 5 957 305

## Beschreibung

Die Erfindung betrifft einen Bestückkopf zum Aufnehmen von Bauelementen äus einer Bauelemente-Zuführeinrichtung, zum Transportieren der aufgenommenen Bauelemente hin zu einer Bestückposition und zum Aufsetzen der Bauelemente auf einen Bauelementeträger.

Die Bestückung von Bauelementeträgern erfolgt üblicherweise in sog. Bestückautomaten. Dabei werden Bauelemente von einer Bauelemente-Zuführeinrichtung von einem Bestückkopf aufgenommen, zu dem zu bestückenden Bauelementeträger transportiert und an einer vorbestimmten Bestückposition auf den Bauelementeträger aufgesetzt. Um eine hohe Bestüekleistung zu erreichen, werden Bestückköpfe verwendet, welche eine Mehrzahl von Haltevorrichtungen aufweisen, so dass bei einem Abholvorgang sequentiell eine Mehrzahl von Bauelementen aufgenommen werden kann und die aufgenommenen Bauelemente an den jeweils vorgesehenen Bestückpositionen sequentiell aufgesetzt werden können.

Als Bestückköpfe sind unter anderem so genannte Matrix-Bestückköpfe bekannt, bei denen entlang einer z-Richtung orientierte Haltevorrichtungen parallel zueinander angeordnet sind und jede Haltevorrichtung uriabhängig von den anderen Haltevorrichtungen relativ zu dem Bestückkopf entlang der z-Richtung verschiebbar ist. Die individuelle Verschiebbarkeit einer jeden Haltevorrichtung kann dadurch erreicht werden, dass für jede Haltevorrichtung ein eigener z-Antrieb vorgesehen ist.

In einem Matrix-Bestückkopf können die einzelnen Haltevorrichtungen allerdings auch mittels eines gemeinsamen z-Antriebs bewegt werden. Dies wird gemäß dem Stand der Technik dadurch erreicht, dass die einzelnen Haltevorrichtungen jeweils individuell an den z-Antrieb ankoppelbar sind.

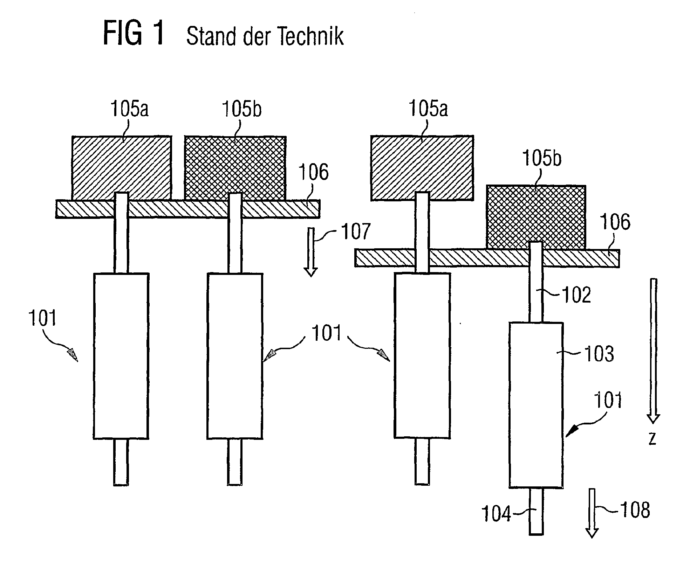

Figur 1 zeigt in einer schematischen Darstellung ein derartiges Ankoppeln von Haltevorrichtungen 101 an ein Mitnahmeelement 106, welches mittels eines nicht dargestellten z-Antrieb entlang der z-Richtung verschiebbar ist. Die Ankopplung der Haltevorrichtungen 101 an das Mitnahmeelement 106, welches ein ferromagnetisches Material aufweist, erfolgt über Elektromagneten 105a, 105b. Die Haltevorrichtungen 101 weisen eine Verbindungsstange 102, eine Dreheinrichtung 103 sowie eine Pipettenhalterung 104 auf. Die Verbindungsstange 102 dient der Befestigung des Elektromagneten 105a bzw. 105b. Die Dreheinrichtung 103 ist dafür vorgesehen, dass von der Haltevorrichtung 101 aufgenommene Bauelemente, die mittels einer nicht dargestellten, an der Pipettenhalterung 104 angebrachten Saugpipette gehalten werden, um die Längsachse der Haltevorrichtung gedreht werden können. Eine nicht dargestellte Federung sorgt dafür, dass die Haltevorrichtungen 101 in einer Ausgangsstellung in eine obere Position gedrückt werden, wie es im linken Teil von Figur 1 dargestellt ist.

Wenn sich das Mitnahmeelement 106 ebenfalls in einer oberen Ausgangsposition befindet (siehe Figur 1 links), dann sind die Elektromagneten 105a bzw. 105b durch eine gezielte Aktivierung, d.h. durch einen entsprechenden Stromdurchfluss an das Mitnahmeelement 106 ankoppelbar. Bei einer in Figur 1 auf der rechten Seite dargestellten Abwärtsbewegung des Mitnahmeelements 106 entlang der z-Richtung wird dann auch die Haltevorrichtung 101, an welcher der aktivierte Elektromagnet 105b befestigt ist, nach unten verschoben. Die Verschiebung der an das Mitnahmeelement 106 angekoppelten Haltevorrichtung 101 ist auf der rechten Seite von Figur 1 durch den Pfeil 108 dargestellt. Die andere Haltevorrichtung, deren zugeordneter Elektromagnet 105a nicht aktiviert ist, verbleibt bei der Abwärtsbewegung des Mitnahmeelements 106 in ihrer Ausgangsposition. Auf diese Weise kann eine Mehrzahl von Haltevorrichtungen bei einer gezielten Aktivierung von einzelnen den Haltevorrichtungen zugeordneten Elektromagneten mittels eines gemeinsamen z-Antriebs entlang der Z-Achse bewegt werden.

Die Verwendung eines gemeinsamen z-Antriebs für eine Mehrzahl von Haltevorrichtungen hat jedoch den Nachteil, dass das ferromagnetische Mitnahmeelement insbesondere dann, wenn eine Mehrzahl von Elektromagneten an dieses Mitnahmeelement ankoppelbar sind, eine große Fläche und damit bei einer bestimmten Mindestdicke auch eine hohe Masse aufweist. Dies führt bei einer Bewegung des Mitnahmeelementes, welches insbesondere bei der Realisierung einer hohen Bestückleistung mit großen Beschleunigungskräften angetrieben wird, zu starken Erschütterungen des Bestückkopfes.

Aus US 2001/0039719 ist eine Bestückvorrichtung bekannt, bei der ein Trägerarm mit einem daran angeordneten Bestückkopf mittels eines Linearmotors parallel zu einer Arbeitsebene verfahrbar ist. Die Arbeitsebene ist auf der Oberseite eines Maschinenrahmens angeordnet. Schnelle Verfahrbewegungen des am Linearmotorläufer befestigten Trägerarms erzeugen in dem Linearmotorständer hohe Reaktionskräfte. Zur Vermeidung von Erschütterungen des Maschinenrahmens aufgrund dieser Reaktionskräfte, ist der Linearmotorständer in der Verfahrrichtung des Trägerarms über Blattfedern mit dem Maschinenrahmen gekoppelt. Durch diese gefederte Lagerung ist der Ständer von dem Maschinenrahmen in der Verfahrrichtung dynamisch entkoppelt, sodass die Übertragung von Reaktionskräften auf den Maschinenrahmen reduziert wird. Trotz der gefederten Lagerung des Ständers kann es zu Schwingungen des Linearmotors und der daran befestigten Teile kommen.

Der Erfindung liegt die Aufgabe zugrunde, einen Bestückkopf zum Aufnehmen, Transportieren und Aufsetzen von Bauelementen zu schaffen, bei dem die durch die Verwendung eines zentralen z-Antriebs erzeugten und auf den Bestückkopf übertragenen Erschütterungen reduziert sind.

Diese Aufgabe wird gelöst durch einen Bestückkopf zum Aufnehmen, Transportieren und Aufsetzen von Bauelementen mit den Merkmalen des unabhängigen Anspruchs 1.

Der Erfindung liegt die Erkenntnis zugrunde, dass durch eine zumindest teilweise mechanische Entkopplung zwischen einem Grundkörper des Bestückkopfes und einem Linearmotor, welcher einen Ständer und einen Läufer aufweist, die auf eine Positioniervorrichtung des Bestückkopfes übertragenen mechanischen Erschütterungen erheblich reduziert werden können. Gemäß der Erfindung ist der Ständer mittels einer Federung federnd an dem Grundkörper gelagert. Der Linearmotor ist derart ausgebildet, dass der Läufer relativ zu dem Ständer entlang der z-Achse bewegbar ist. Der erfindungsgemäße Bestückkopf weist ferner zumindest eine Haltevorrichtung auf, welche beispielsweise eine so genannte Saugpipette umfasst, welche ein Bauelement mittels eines an die Saugpipette angelegten Unterdrucks aufnehmen kann. Die Haltevorrichtung ist relativ zu dem Grundkörper entlang der z-Achse verschiebbar gelagert und kann an den Läufer des Linearmotors angekoppelt werden, so dass bei einer Bewegung des Läufers entlang der z-Achse auch die Haltevorrichtung entlang der z-Achse bewegt wird.

Gemäß der Erfindung ist zusätzlich ein Wegaufnehmer zur Erfassung der Verschiebung des Läufers relativ zu dem Grundkörper vorgesehen. Als Wegaufnehmer eignet sich dabei insbesondere ein so genannter Inkrementalgeber. Die Messung des Verschiebeweges des Läufers relativ zu dem Grundkörper hat den Vorteil, dass die für den Bestückvorgang relevante Verschiebestrecke einer an den Läufer angekoppelten Haltevorrichtung erfasst wird. Daneben umfasst der Bestückkopf noch einen zweiten Wegaufnehmer zur Erfassung der Verschiebung des Ständers relativ zu dem Grundkörper. Bevorzugt ist der zweite Wegaufnehmer ein Inkrementalgeber. Ferner weist der erfindungsgemäße Bestückkopf zusätzlich einen Stellantrieb und eine Steuerungseinrichtung auf, welche mit dem ersten Wegaufnehmer, mit dem zweiten Wegaufnehmer und mit dem Stellantrieb gekoppelt ist. Mittels der Steuerungseinrichtung wird der Stellantrieb, welcher sich zwischen dem Grundkörper und dem Ständer befindet, derart angesteuert, dass nach einer durch eine Bewegung des Läufers verursachten Verschiebung des Ständers dieser in seiner Position verbleibt. Die Position des Massenschwerpunkts des Linearmotors bleibt auf diese Weise erhalten, so dass der Linearmotor zumindest annähernd ein Bewegungsverhalten zeigt, welches dem Bewegungsverhalten eines Linearmotors entspricht, welcher nicht der Gravitationskraft ausgesetzt ist und welcher somit keine oder nur sehr geringe Schwingungen auf die Positioniervorrichtung überträgt.

Gemäß Erfindung wird die Gegenkraft der zur Beschleunigung des Läufers erforderlichen Kraft in den Ständer eingeleitet und von diesem nicht an die Positioniervorrichtung übertragen, da die Gegenkraft durch eine Ausweichbewegung des Ständers aufgenommen wird. Da im Allgemeinen die Masse des Ständers deutlich größer ist als die Masse des Läufers, unterscheidet sich der Beschleunigungsverlauf dieser beiden Komponenten des Linearmotors erheblich voneinander. Das Verhältnis der auftretenden Beschleunigungen ist dabei umgekehrt proportional zu dem Verhältnis der Massen der beiden Komponenten. Der zurückgelegte Weg der beiden Komponenten ist direkt proportional zu der jeweiligen Beschleunigung der Komponente. Somit ergibt sich beispielsweise bei einer Ständermasse von 1500 g und einer Läufermasse von 300 g eine um den Faktor 5 unterschiedliche Beschleunigung sowie einen um den Faktor 5 unterschiedlichen Verschiebeweg der beiden Komponenten des Linearmotors. Bei einer Verschiebung des Läufers entlang der z-Achse von 10 mm nach unten ergibt sich in dem genannten Beispiel eine Verschiebung des Ständers entlang der z-Achse von 2 mm nach oben.

Die federnde Lagerung des Ständers an dem Grundkörper des Bestückkopfs hat den Vorteil, dass durch die Bewegung des Läufers lediglich geringe Kräfte auf den Grundkörper des Bestückkopfs übertragen werden. Damit sind die Schwingungsamplituden, die in der Positioniervorrichtung angeregt werden, deutlich reduziert, so dass sich der Bestückkopf relativ zu dem zu bestückenden Bäuelementeträger sehr genau positionieren lässt. Ein weiterer Vorteil des erfindungsgemäßen Bestückkopfes besteht darin, dass die bei bekannten Bestückköpfen sehr hohen Steifigkeits-Anforderungen an die Positioniervorrichtung reduziert werden können und somit Positioniervorrichtungen mit geringerer Masse verwendet werden können, so dass auch die Bestückgeschwindigkeit ohne eine Verschlechterung der Bestückgenauigkeit erhöht werden kann.

Der Stellantrieb kann ferner Kraftänderungen aufnehmen, die im allgemeinen klein sind und die ohne die Bestückgenauigkeit zu reduzieren, an die Positioniervorrichtung weitergegeben werden können. Derartige Kraftänderungen treten beim Ein- bzw. beim Ausfedern der zwischen dem Grundkörper und dem Ständer vorhandenen Federung beispielsweise infolge des Hook'schen Gesetzes auf. Außerdem treten kleine Kraftänderungen dadurch auf, dass beim Aufnehmen bzw. beim Aufsetzen der Bauelemente die Haltevorrichtung mit einer bestimmten Kraft gegen das Bauelement drückt, welches sich in der Bauelemente-Zuführeinrichtung bzw. auf dem Bauelementeträger befindet.

Durch die Vermessung der Verschiebung des Ständers relativ zu dem Grundkörper kann die aktuelle Position des Ständers erfasst werden und somit durch eine geeignete Ansteuerung des Stellantriebs einem langsamen Zurückdriften des Ständers in seine Ausgangslage, entgegengewirkt werden. Damit sind die Verschiebewege von Läufer und Ständer auch für längere Zeiten umgekehrt proportional zur Masse dieser beiden Komponenten des Linearmotors.

Es wird darauf hingewiesen, dass die Steuerungseinrichtung aufgrund der Rückkopplung des zweiten Wegaufnehmers mit dem Stellantrieb eine Regelung der Position des Ständers bewirkt, die gewährleistet, dass die Position des Massenschwerpunkts des Linearmotors trotz der zuvor beschriebenen Kraftänderungen erhalten bleibt.

Gemäß Anspruch 2 ist der Läufer an dem Grundkörper gelagert. Dies wird bevorzugt mittels einer Linearführung realisiert, welche an dem Grundkörper befestigt ist.

Gemäß Anspruch 3 ist die Haltevorrichtung an ein Mitnahmeelement mechanisch und/oder magnetisch ankoppelbar. Ein mechanisches Ankoppeln kann beispielsweise durch ein Eingreifen der Haltevorrichtung in eine eine Verjüngung aufweisende Aussparung des Mitnahmeelements erfolgen. Die magnetische Ankopplung erfolgt bevorzugt mittels eines Elektromagneten, welcher an dem Mitnahmeelement und/oder an der Haltevorrichtung angeordnet ist.

Die federnde Lagerung des Ständers an dem Grundkörper mittels einer pneumatischen Federung gemäß Anspruch 4 hat den Vorteil, dass zwischen Grundelement und Linearmotor eine besonders gute Entkopplung der mechanischen Schwingungen erreicht wird.

Bei dem Bestückkopf nach Anspruch 5 liegen die Bewegungsvektoren der Massenschwerpunkte von Ständer und Läufer auf einer gemeinsamen Achse. Auf diese Weise wird auch bei einer Bewegung des Läufers mit großer Beschleunigung kein resultierendes Drehmoment erzeugt, so dass in die Positioniervorrichtung keine oder lediglich sehr geringe Drehmomente eingeleitet werden. Auf diese Weise kann die erzielbare Bestückgenauigkeit weiter erhöht werden.

Der Bestückkopf nach Anspruch 6 weist eine Mehrzahl von Haltevorrichtungen auf, welche unabhängig voneinander an den Läufer ankoppelbar sind und welche entlang einer Reihe oder an den Gitterpunkten eines zweidimensionalen Rasters angeordnet sind. Die Haltevorrichtungen sind dabei parallel zueinander ausgerichtet und senkrecht zur z-Achse voneinander beabstandet.

Gemäß der Ausführungsform nach Anspruch 7 ist der Stellantrieb in die Federung integriert. Bei Verwendung einer pneumatischen Federung wird dabei die zwischen dem Grundelement und dem Ständer befindliche Luftmenge derart reguliert, dass die oben beschriebenen Kraftänderungen durch die von der Luftmenge abhängige Federkraft der pneumatischen Federung kompensiert werden und nicht zu einer Veränderung des Abstandes zwischen dem Grundelement und dem Ständer führen.

Weitere Vorteile und Merkmale der vorliegenden Erfindung ergeben sich aus der folgenden beispielhaften Beschreibung derart bevorzugter Ausführungsformen.

In der Zeichnung zeigen in schematischen Darstellungen
- Figur 1: das selektive Ankoppeln einer Haltevorrichtung an die Bewegung eines gemeinsamen Mitnahmeelements gemäß dem Stand der Technik,
- Figur 2: ein Blockschaltbild des mechanischen Systems eines Bestückkopfes gemäß einem Ausführungsbeispiel der Erfindung,
- Figur 3: den Aufbau eines Bestückkopfes gemäß einem Ausführungsbeispiel der Erfindung und
- Figur 4: ein Blockschaltbild der Steuerungseinrichtung zur Regelung des Stellantriebs gemäß einem Ausführungsbeispiel der Erfindung.

An dieser Stelle bleibt anzumerken, dass sich die Bezugszeichen einander entsprechender Komponenten lediglich in ihrer ersten Ziffer unterscheiden.

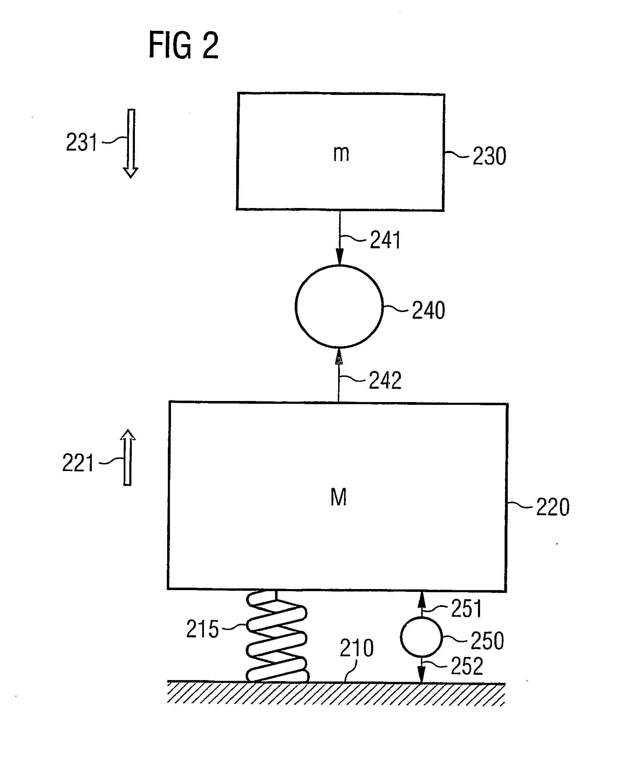

Wie aus dem in Figur 2 dargestellten Blockschaltbild ersichtlich, ist ein Ständer 220 eines Linearmotors über eine Federung 215 mit einem Grundkörper 210 des Bestückkopfes mechanische gekoppelt. Der Linearmotor umfasst neben dem Ständer 220 auch einen Läufer 230. Die mechanische Kopplung zwischen dem Ständer 220 und dem Läufer 230 ist schematisch durch einen Linearantrieb 240 dargestellt.

Im folgenden werden die bei einer Bewegung des Linearmotors auftretenden Kräfte und Gegenkräfte für den Fall erläutert, dass der Läufer 230 nach unten bewegt wird. In diesem Fall bewirkt der Linearantrieb 240 eine Kraft 241, die auf den Läufer 230 wirkt und diesen nach unten zieht. Dabei entsteht infolge des Newton'schen Grundsatzes actio gleich reactio eine Gegenkraft 242, die auf den Ständer 220 wirkt und diesen nach oben zieht. Im folgenden wird sich aufgrund der Kraftwirkung der beiden Kräfte 241 und 242 der Läufer 230 entlang der Verschieberichtung 231 nach unten und der Ständer 220 entlang der Verschieberichtung 221 nach oben bewegen.

Da die Masse des Läufers 230 im allgemeinen kleiner ist als die Masse des Ständers 220, sind auch die resultierenden Verschiebewege unterschiedlich lang. Die unterschiedliche Längen der Verschiebewege sind durch die Länge der Verschiebepfeile 231 bzw. 221 angedeutet.

Um zu gewährleisten, dass nach einer Bewegung des Linearmotors der Ständer 220 exakt in der Position verbleibt, in der er aufgrund der Bewegung der trägen Masse des Läufers bewegt worden ist, ist zwischen dem Grundkörper 210 und dem Ständer 220, d.h. parallel zu der Federung 215, zusätzlich ein Stellantrieb 250 vorgesehen. Der Stellantrieb 250 hat die Aufgabe, dass nach einer Ausweichbewegung des Ständers 220, welche durch eine Bewegung der trägen Masse des Läufers 230 verursacht wurde, der Ständer in seiner Stellung verbleibt.

Sofern die Federkonstante der Federung 215 sowie die Vorspannung der Federung 215 in einer Ausgangsposition des Ständers 220 gerade so gewählt ist, dass die Federkraft der Federung 215 gerade die Gewichtskraft des gesamten Linearmotors kompensiert, entspricht das Bewegungsverhalten des Läufers 230 und des Ständers 220 im idealen Fall einem im Raum ohne Einfluss der Gewichtskraft frei schwebenden Linearmotor. Anders ausgedrückt bedeutet dies, dass die Lage des Massenschwerpunkts des Linearmotors erhalten bleibt.

Um dies mit hoher Genauigkeit zu erreichen, muss der Stellantrieb 250 eine Reihe von kleineren Kräften aufnehmen, die im realen Betrieb des Bestückkopfes auftreten. Im folgenden werden anhand einer nicht abschließenden Aufzählung einige dieser Kräfte erläutert:
(1) Nach einer Verschiebung des Ständers 220 aus seiner Ausgangsposition heraus hat die Federung 215 die Tendenz, den Ständer 220 in seine Ausgangsposition zurück zu bringen. Um dies zu verhindern, nimmt der Stellantrieb 250 diejenige Kraft auf, die durch eine Auslenkung des Ständers 220 aus seiner Ausgangsposition auftritt.. Nach einer Verschiebung des Ständers 220 nach oben muss der Stellantrieb 250 demzufolge auf den Ständer 220 eine nach oben gerichtete Kraft 251 und auf den Grundkörper 210 eine nach unten gerichtete Gegenkraft 252 ausüben. Bei einer mechanischen Federung 215 entsprechen diese Kräfte der durch eine Federauslenkung erzeugten Kraftänderung, die durch das so genannte Hook'sche Gesetz beschrieben wird. Bei einer pneumatischen Federung treten analoge Kräfte auf, die ebenfalls durch einen Stellantrieb oder auch durch eine pneumatische Nachregelung der pneumatischen Federung kompensiert werden können. Eine derartige Nachregelung ist allerdings für sehr kurze Zeiten schwierig zu realisieren, so dass der Stellantrieb 250 im Falle einer pneumatisch geregelten pneumatischen Federung 215 insbesondere die entsprechenden kurzzeitigen Kraftänderungen aufnimmt.
(2) Beim Aufnehmen von Bauelementen wird die Haltevorrichtung auf das aufzunehmende Bauelement aufgesetzt. Dabei tritt für kurze Zeit eine Aufsetzkraft auf, die ebenfalls von dem Stellantrieb 250 kompensiert wird.
(3) Beim Aufsetzen von Bauelementen auf einen Bauelementeträger tritt in analoger Weise eine Aufsetzkraft auf, die ebenso von dem Stellantrieb 250 aufgenommen wird.
(4) Der Stellantrieb 250 muss ferner für jede an den Läufer 230 angekoppelte Haltevorrichtung eine Kraft aufnehmen, die sich aus der Gewichtskraft der Haltevorrichtung und einer Federkraft der Haltevorrichtung ergibt, mit der die Haltevorrichtung in ihre Ausgangsposition gedrückt wird.
(5) Außerdem muss der Stellantrieb 250 Reibungskräfte kompensieren, die beispielsweise bei einer Bewegung des Ständers 220, des Läufers 230 und der Haltevorrichtungen in den jeweiligen Lagerungen entstehen.

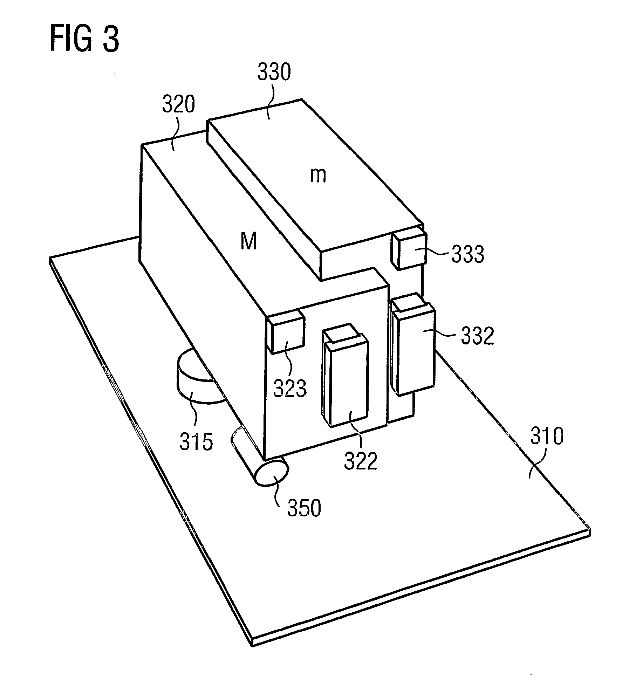

Figur 3 zeigt in einer schematischen Darstellung einen federnd gelagerten Linearmotor eines Bestückkopfes gemäß einem Ausführungsbeispiel der Erfindung. Der Bestückkopf weist einen Grundkörper 310 auf, welcher mittels einer nicht dargestellten Positioniervorrichtung zwischen einem Abholbereich für Bauelemente und einem Aufsetzbereich für Bauelemente auf einem Bauelementeträger positioniert werden kann. Der Ständer 320 des Linearmotors ist relativ zu dem Grundkörper 310 entlang einer z-Achse verschiebbar gelagert. Die Lagerung des Ständers 320 erfolgt mittels einer Linearführung 322. Ferner ist der Grundkörper 310 mittels einer pneumatischen Federung 315 mit dem Ständer 320 gekoppelt. Zwischen dem Grundkörper 310 und dem Ständer 320 ist ferner ein Wegaufnehmer 323 vorgesehen, welcher die Verschiebung des Ständers 320 relativ zu dem Grundkörper 310 erfasst.

Der Läufer 330 des Linearmotors ist relativ zu dem Ständer 320 entlang der z-Achse verschiebbar gelagert. Für die Lagerung des Läufers 330 ist ebenfalls eine Linearführung 332 vorgesehen, welche den Läufer 330 entweder relativ zu dem Ständer 320 oder relativ zu dem Grundkörper 310 derart lagert, dass der Läufer 330 lediglich entlang der z-Achse bewegbar ist. Zur Erfassung des Verschiebeweges des Läufers 330 ist ein Wegaufnehmer 333 vorgesehen, welcher entweder die Verschiebung des Läufers 330 relativ zu dem Ständer 320 oder die Verschiebung des Läufers 330 relativ zu dem Grundkörper 310 erfasst. Dabei hat die Erfassung der Verschiebung relativ zu dem Grundkörper 310 den Vorteil, dass die für eine Bestückung von Bauelementen relevante Bewegung des Läufers 330 direkt erfasst wird.

Der Stellantrieb 350, welcher zwischen dem Grundkörper 310 und dem Ständer 320 angeordnet ist, wurde bereits zuvor anhand von Figur 2 erläutert.

Bevorzugt werden die Massenverteilungen des Ständers 320 und des Läufer 330 derart gewählt, dass bei einer Bewegung des Linearmotors die Massenschwerpunkte von Ständer 320 und Läufer 330 stets auf einer gemeinsamen Achse liegen. Auf diese Weise wird bei einer Bewegung des Linearmotors keinerlei Drehmoment erzeugt, so dass auf die Positioniervorrichtung, welche an dem Grundkörper 310 des Bestückkopfes angreift, auch bei einer Bewegung des Linearmotors mit großen Beschleunigungen keinerlei Drehmoment übertragen wird.

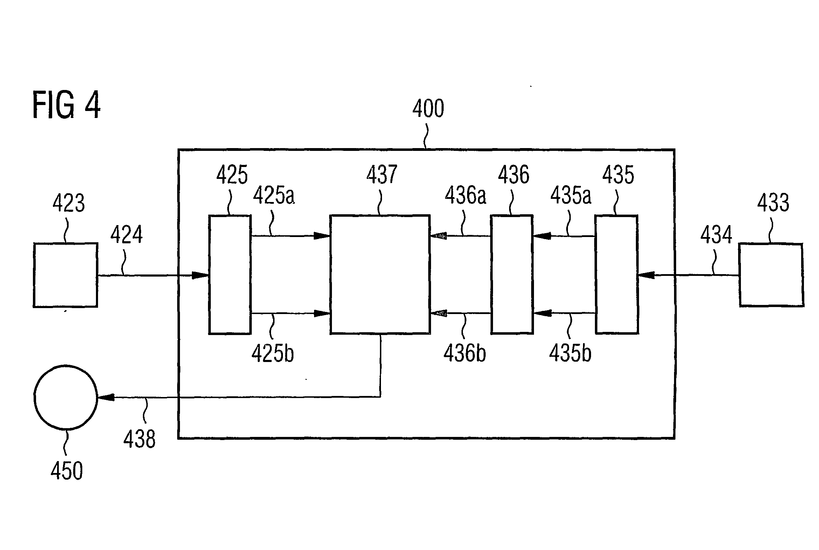

Die Regelung der Position des Ständers 320 erfolgt gemäß einem Ausführungsbeispiel der Erfindung mittels einer Regelungseinrichtung 400, welche in Figur 4 dargestellt ist. Die Regelungseinrichtung 400 weist zwei Eingänge auf, die mit dem Wegaufnehmer 433 des Läufers sowie mit dem Wegaufnehmer 423 des Ständers jeweils über eine Signalleitung verbunden sind. Ein Ausgang der Regelungseinrichtung 400 ist mit dem Stellantrieb 450 verbunden. Da eine durch den Stellantrieb 450 bewirkte Verschiebung des Ständers unmittelbar von dem Wegaufnehmer 423 erfasst wird, stellt die Verbindung zwischen dem Wegaufnehmer 423 des Ständers und der Regelungseinrichtung 400 eine Rückkopplung dar, so dass die Position des Ständers geregelt wird.

Im Folgenden wird die Funktion der Regelungseinrichtung 400 beschrieben: Der Wegaufnehmer 433 des Läufers übergibt ein Signal 434 an eine Signalverarbeitungseinheit 435, welche als Ausgangsgrößen jeweils ein der Ist-Position des Läufers entsprechendes Signal 435a sowie ein der Ist-Geschwindigkeit des Läufers entsprechendes Signal 435b bereitstellt. Diese beiden Signale 435a und 435b werden an eine Recheneinheit 436 übergeben, die aufgrund der bekannten Massenverhältnisse zwischen Ständer und Läufer ein Signal 436a sowie ein Signal 436b ermittelt. Das Signal 436a repräsentiert die Soll-Position des Ständers. Das Signal 436b repräsentiert die Soll-Geschwindigkeit des Ständers.

Der Wegaufnehmer 423 für den Ständer übergibt in analoger Weise ein Signal 424 an eine Signalverarbeitungseinheit 425, welche als Ausgangsgrößen jeweils ein der Ist-Position des Ständers entsprechendes Signal 425a sowie ein der Ist-Geschwindigkeit des Ständers entsprechendes Signal 425b bereitstellt.

Die Signale 425a und 425b, welche die Ist-Position und die Ist-Geschwindigkeit des Ständers repräsentieren sowie die Signale 436a und 436b, welche die Soll-Position und die Soll-Geschwindigkeit des Ständers repräsentieren, werden an eine Regeleinheit 437 übergeben, welche ein Signal 438 für den Stellantrieb 450 ausgibt. Auf diese Weise wird die Position des Ständers mittels des Stellantriebs 450 derart geregelt, dass der Ständer stets an der Position verbleibt, die er aufgrund einer Bewegung der trägen Masse des Läufers annimmt.

Zusammenfassend schafft die Erfindung einen Bestückkopf zum Aufnehmen, Transportieren und Aufsetzen von Bauelementen mit einem Grundkörper 310, einem Linearmotor sowie zumindest einer Haltevorrichtung. Der Linearmotor umfasst einen Ständer 320 und einen Läufer 330. Der Ständer 320 ist federnd an dem Grundkörper 310 gelagert. Der Läufer 330 ist relativ zu dem Ständer 320 entlang einer z-Achse bewegbar. Die Haltevorrichtung ist ebenfalls entlang der z-Achse verschiebbar gelagert und an den Läufer 330 ankoppelbar. Durch die federnde Lagerung des Ständers 320 an dem Grundkörper 310 werden Schwingungen, welche bei einer ruckartigen Bewegung des Linearmotors erzeugt werden, lediglich in geringem Maße auf den Grundkörper 310 übertragen. Durch eine aktive Regelung der Position des Ständers 320 mittels eines Stellantriebs 350 wird gewährleistet, dass die Position des Massenschwerpunkts des Linearmotors erhalten bleibt. Die Regelung des Stellantriebs erfolgt mittels Wegaufnehmern 323 bzw. 333, welche die Verschiebungen des Ständers 320 und des Läufers 330 relativ zu dem Grundkörper 310 erfassen.

### Bezugszeichenliste

- 101: Haltevorrichtung
- 102: Verbindungsstange
- 103: Dreheinrichtung
- 104: Pipettenhalterung
- 105a: Elektromagnet (passiv)
- 105b: Elektromagnet (aktiv)
- 106: Mitnahmeelement
- 107: Verschiebung der Mitnahmeelement
- 108: Verschiebung der angekoppelten Haltevorrichtung

- 210: Grundkörper
- 215: Federung
- 220: Ständer
- 221: Verschiebung Ständer
- 230: Läufer
- 231: Verschiebung Läufer
- 240: Linearantrieb
- 241: Kraft
- 242: Gegenkraft
- 250: Stellantrieb
- 251: Kraft
- 252: Gegenkraft

- 310: Grundkörper
- 315: pneumatische Federung
- 320: Ständer
- 322: Linearführung Ständer
- 323: Wegaufnehmer Ständer
- 330: Läufer
- 332: Linearführung Läufer
- 333: Wegaufnehmer Läufer
- 350: Stellantrieb

- 400: Regelungseinrichtung
- 423: Wegaufnehmer Ständer
- 424: Signal Wegaufnehmer Ständer
- 425: Signalverarbeitungseinheit
- 425a: Signal Ist-Position Ständer
- 425b: Signal Ist-Geschwindigkeit Ständer
- 433: Wegaufnehmer Läufer
- 434: Signal Wegaufnehmer Läufer
- 435: Signalverarbeitungseinheit
- 435a: Signal Ist-Position Läufer
- 435b: Signal Ist-Geschwindigkeit Läufer
- 436: Recheneinheit
- 436a: Signal Soll-Position Läufer
- 436b: Signal Soll-Geschwindigkeit Läufer
- 437: Regeleinheit für Position/Geschwindigkeit Ständer
- 438: Signal für Stellantrieb
- 450: Stellantrieb

## Patentansprüche

1. Bestückkopf zum Aufnehmen, Transportieren und Aufsetzen von Bauelementen mit
• einem Grundkörper (310),
• einem Linearmotor, welcher einen Ständer (320) und einen Läufer (330) aufweist, wobei
- der Ständer (320) mittels einer Federung (315) federnd an dem Grundkörper (310) gelagert ist und
- der Läufer (330) relativ zu dem Ständer (320) entlang einer z-Achse bewegbar ist,
• zumindest einer Haltevorrichtung,
- welche relativ zu dem Grundkörper (310) entlang der z-Achse verschiebbar gelagert ist und
- welche an den Läufer (330) ankoppelbar ist, so dass bei einer Bewegung des Läufers (330) auch die Haltevorrichtung entlang der z-Achse bewegt wird,
• einem ersten Wegaufnehmer (333) zur Erfassung der Verschiebung des Läufers (330) relativ zu dem Grundkörper (310),
• einem zweiten Wegaufnehmer (323) zur Erfassung der Verschiebung des Ständers (320) relativ zu dem Grundkörper (310),
• einem Stellantrieb (350), welcher zwischen dem Grundkörper (310) und dem Ständer (320) angeordnet ist, und
• einer Steuerungseinrichtung, welche mit dem ersten Wegaufnehmer (333), mit dem zweiten Wegaufnehmer (323), und mit dem Stellantrieb (350) gekoppelt ist,
wobei der Stellantrieb (350) derart von der Steuerungseinrichtung ansteuerbar ist, dass nach einer durch eine Bewegung des Läufers (330) verursachten Verschiebung des Ständers (320) dieser in seiner Position verbleibt.

2. Bestückkopf nach Anspruch 1, bei dem der Läufer (330) relativ zu dem Grundkörper (310) gelagert ist.

3. Bestückkopf nach einem der Ansprüche 1 bis 2, bei dem der Läufer (330) zusätzlich ein Mitnahmeelement aufweist, welches derart ausgebildet ist, dass die Haltevorrichtung an das Mitnahmeelement mechanisch und/oder magnetisch ankoppelbar ist.

4. Bestückkopf nach einem der Ansprüche 1 bis 3, bei dem die Federung (315) eine pneumatische Federung ist.

5. Bestückkopf nach einem der Ansprüche 1 bis 4, bei dem der Ständer (320) derart geformt ist, dass der Massenschwerpunkt des Ständers (320) und der Massenschwerpunkt des Läufers (330) auf einer Achse liegen, welche zumindest annähernd parallel zur z-Achse verläuft.

6. Bestückkopf nach einem der Ansprüche 1 bis 5, mit einer Mehrzahl von Haltevorrichtungen,
• welche entlang einer Reihe oder an den Gitterpunkten eines zweidimensionalen Rasters angeordnet sind und
• welche unabhängig voneinander an den Läufer (330) ankoppelbar sind.

7. Bestückkopf nach einem der Ansprüche 1 bis 6, bei dem der Stellantrieb in der Federung (315) integriert ist.

## Claims

1. Pick-and-place head for lifting, transporting and placing components with
• a chassis unit (310),
• a linear motor, which features a stator (320) and a rotor (330), with
- the stator (320) being supported by means of springing (315) sprung on the chassis unit (310) and
- the rotor (330) being able to be moved relative to the stator (320) along a z-axis,
• at least one holder device,
- which is supported so that it can be moved relative to the chassis unit (310) along the z-axis and
- which is able to be coupled to the rotor (330), so that for a movement of the rotor (330), the holder device is also moved along the z-axis,
• a first movement recorder (333) for recording the movement of the rotor (330) relative to the chassis unit (310),
• a second movement recorder (323) for recording the movement of the stator (320) relative to the chassis unit (310),
• an actuator (350), which is arranged between the chassis unit (310) and the stator (320), and
• a control device, which is coupled to the first movement recorder (333), to the second movement recorder (323), and to the actuator (350),
with the actuator (350) being able to be activated by the control device such that, after a movement of the stator (320) caused by a movement of the rotor (330) the stator remains in its position.

2. Pick-and-place head in accordance with claim 1, in which the rotor (330) is supported relative to the chassis unit (310).

3. Pick-and-place head in accordance with one of the claims 1 to 2, in which the rotor (330) additionally features a driver element which is embodied such that the holder device can be mechanically and/or magnetically coupled to the driver element.

4. Pick-and-place head in accordance with one of the claims 1 to 3, in which the springing (315) is pneumatic springing.

5. Pick-and-place head in accordance with one of the claims 1 to 4, in which the stator (320) is formed such that the centre of mass of the stator (320) and the centre of mass of the rotor (330) lie on one axis which runs at least approximately parallel to the z-axis.

6. Pick-and-place head in accordance with one of the claims 1 to 5, with a plurality of holder devices,
• which are arranged along a row or at the grid points of a two-dimensional grid and
• which can be coupled to the rotor (330) independently of each other.

7. Pick-and-place head in accordance with one of the claims 1 to 6, in which the actuator is integrated into the springing (315) .

## Revendications

1. Tête d'insertion pour la saisie, le transport et la pose de composants, comprenant
• un corps de base (310),
• un moteur linéaire pourvu d'un stator (320) et d'un rotor (330),
- le stator (320) étant monté de manière élastique sur le corps de base (310) au moyen d'une suspension (315) et
- le rotor (330) étant mobile par rapport au stator (320) le long d'un axe Z,
• au moins un dispositif de retenue
- qui est monté de manière à pouvoir être déplacé par rapport au corps de base (310) le long de l'axe Z et
- qui peut être accouplé au rotor (330) de manière à ce que, lors d'un mouvement du rotor (330), le dispositif de retenue soit également déplacé le long de l'axe Z,
• un premier capteur de déplacement (333) pour la saisie du déplacement du rotor (330) par rapport au corps de base (310),
• un second capteur de déplacement (323) pour la saisie du déplacement du stator (320) par rapport au corps de base (310),
• un servomoteur (350) situé entre le corps de base (310) et le stator (320) et
• un dispositif de commande couplé au premier capteur de déplacement (333), au second capteur de déplacement (323) et au servomoteur (350),
le servomoteur (350) pouvant être commandé par le dispositif de commande de manière à ce qu'après un déplacement du stator (320) provoqué par un mouvement du rotor (330), le stator reste dans sa position.

2. Tête d'insertion selon la revendication 1, dans laquelle le rotor (330) est monté par rapport au corps de base (310).

3. Tête d'insertion selon l'une des revendications 1 à 2, dans laquelle le rotor (330) est pourvu, en outre, d'un élément d'entraînement exécuté de manière à ce que le dispositif de retenue puisse être accouplé à l'élément d'entraînement de manière mécanique et/ou magnétique.

4. Tête d'insertion selon l'une des revendications 1 à 3, dans laquelle la suspension (315) est une suspension pneumatique.

5. Tête d'insertion selon l'une des revendications 1 à 4, dans laquelle le stator (320) est formé de manière à ce que le centre de gravité de la masse du stator (320) et le centre de gravité de la masse du rotor (330) soient situés sur un axe s'étendant au moins à peu près parallèlement à l'axe Z.

6. Tête d'insertion selon l'une des revendications 1 à 5, comprenant une pluralité de dispositifs de retenue
• qui sont disposés le long d'une rangée ou au niveau des points de grille d'une grille bidimensionnelle et
• qui peuvent être accouplés au rotor (330) de manière indépendante les uns des autres.

7. Tête d'insertion selon l'une des revendications 1 à 6, dans laquelle le servomoteur est intégré dans la suspension (315).
